# EUROPEAN PATENT APPLICATION

(11) **EP 4 542 639 A1**
(43) Date of publication of application: **23.04.2025**
(21) Application number: 23208513.4
(22) Date of filing: 08.11.2023
(51) Int. Cl.: H01L 23/31, H01L 23/495, H01L 21/56, H01L 23/433

(54) **A QFN PACKAGED SEMICONDUCTOR DEVICE AND METHOD**

(30) Priority: 20.10.2023 CN 202311367880
(71) Applicant: NXP USA, Inc., Austin TX 78735 (US)
(72) Inventor: Ge, You, 5656AG Eindhoven (NL); Wang, Zhijie, 5656AG Eindhoven (NL); Lee, Yit Meng, 5656AG Eindhoven (NL); Shah, Ankur Shailesh, 5656AG Eindhoven (NL); Saiyajitara, Amornthep, 5656AG Eindhoven (NL)
(74) Representative: Hardingham, Christopher Mark

(57) **Abstract**

Disclosed is a QFN packaged semiconductor device (100), having a first major surface (102), an opposing second major surface (204) and sidewalls (206) therebetween, and comprising: a lead-frame (210), having a lead-frame lower surface and comprising a central die-pad region (212) and a plurality of peripheral landing regions (214); a semiconductor die (220), attached to the die-pad on a top surface thereof; a plurality of bond-wires (230) providing electrical connection between the semiconductor die (220) and the plurality of peripheral landing regions (214); and encapsulant material (240), encapsulating the semiconductor die (220) and bond-wires (230); wherein the encapsulant material (240) forms a frame (242) extending below the lead-frame lower surface, and defining the second major surface (204), the frame (242) having an opening therein in a central region thereof under the semiconductor die (220), and wherein the sidewalls (206) are spaced apart from the frame (242) thereby exposing the lead-frame lower surface at the plurality of peripheral landing regions.

## Description

### Field

The present disclosure relates to packaged semiconductor devices, and in particular to so-called quad flat no-lead ("QFN") devices.

### Background

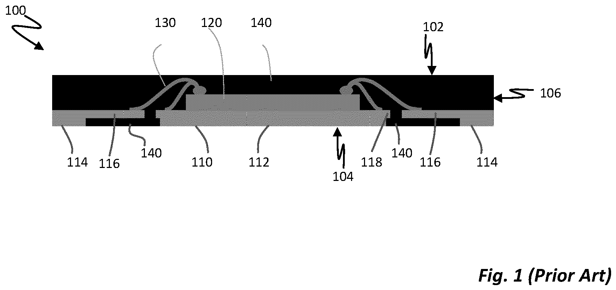

QFN devices are a category of packaged semiconductor devices which do not include leads of flying leads protruding from the encapsulant material which forms the basis of the package. Figure 1 shows a cross-section through a conventional QFN device 100. The QFN device has a top, or first, major surface 102, which is defined by molding compound or encapsulant 140, a bottom, or second, major surface 104, and sidewalls 106. A semiconductor die 120 is embedded in the device. In contrast to many other types of semiconductor packages, the QFN package does not have protruding leads for electrical contact. Instead, electrical connection to the embedded semiconductor die 120 is made to separate parts of a lead-frame 110, which are within the - generally cuboid - envelop of the package itself. In particular, the substrate of the semiconductor die 120 is electrically connected to a die pad 112 which forms a central region of the lead-frame. Contact pads on the upper surface of the semiconductor die are connected by means of wirebonds 130 to other parts of the lead-frame. The other parts are arranged around the periphery of the QFN device and are generally referred to as landing regions or landings. In FIG. 1 two landing regions 114 are shown. The landing regions 114 are separated from, and electrically isolated from, each other and from the central die pad 112, by encapsulant 140. The lower surfaces of the landing regions 114 of the die pad 112, and of the encapsulant 140 which separates both the landing regions from each other and separates the landing regions from the central die pad together define the bottom, or second, major surface 104 of the device.

As will be familiar to the skilled person, the lead-frame is provided or supplied typically along with several or many other lead-frames, as an integral, or single, component, in a reel or sheet form. The die pad and peripheral landing regions are connected together and to each other by a bar or frame around the outside of the lead-frame, which is removed during subsequent processing and particular during singulation of the packaged semiconductor device. Removal of the frame electrically isolates the various component parts of the lead-frame.

In order to ensure that the wirebonds 130 which connect the contact pads of the semiconductor die 120 to the peripheral landing regions, are not overly long, the peripheral landing regions must approach relatively close to the die. However, this would provide a risk of an electrical short when the QFN device is mounted on a circuit board or the like. In particular there may be insufficient separation between the solder attaching the peripheral landing regions114 and the solder attaching the die pad 112. In conventional QFN devices, this problem is solved by providing a lead-frame which is partially thinned, such as by "half-etching" to locally reduce its thickness by approximately 50%.. In particular the lower surface of the innermost parts of the peripheral landing regions is recessed, as shown in FIG. 1, to result in a thinner part 116 of the lead-frame. The recess may include an outer perimeter of the die pad as shown at 118.

Providing a lead-frame with recessed regions, by for instance etching or pressing, increases the cost of the lead-frame. Furthermore, manufacturing tolerances of the thinning process introduces variability to the thickness of the thinner region 116 which may adversely affect the reliance of the wire bonds.

### Summary

According to a first aspect of the present disclosure, there is provided A quad flat no-leads (QFN) packaged semiconductor device, having a first major surface, an opposing second major surface and sidewalls therebetween, and comprising: a lead-frame, having a lead-frame lower surface and comprising a central die-pad region and a plurality of peripheral landing regions; a semiconductor die, attached to the die-pad on a top surface thereof; a plurality of bond-wires providing electrical connection between the semiconductor die and the plurality of peripheral landing regions; and encapsulant material, encapsulating the semiconductor die and bond-wires and defining the first major surface; wherein the encapsulant material forms a frame extending below the lead-frame lower surface, and defining the second major surface, the frame having an opening therein in a central region thereof under the semiconductor die, and wherein the sidewalls are spaced apart from the frame thereby exposing the lead-frame lower surface at the plurality of peripheral landing regions. By providing a frame of encapsulant material which extends below the lower surface of the lead-frame, embodiments of the present disclosure may utilise a lead-frame which does not require a partial thickness region. Reliability of wire bonding to the lead-frame may be improved since all the bond sites are on full-thickness lead-frame.

In one or more embodiments, the lead-frame has a uniform thickness. This may reduce the complexity of the lead-frame itself thereby simplifying and reducing cost.

In one or more embodiments, the peripheral landing regions are separated by encapsulant. Conventional injection molding may be used to provide the encapsulant between individual peripheral landing regions.

In one or more embodiments, the QFN semiconductor device package further comprises a solder material in the opening. Providing solder in the opening may protect the die pad, and provide a more robust device. It may further simplify integration of the device onto a printed circuit board or the like.

In one or more embodiments, the solder material in the opening forms part of the second major surface. This may simplify placement of the devices on a PCB or the like.

In one or more embodiments, the QFN semiconductor device package further comprises solder material attaching to the peripheral landings. Providing solder material on the peripheral landings may help protect the landings themselves, and may assist in attaching the device on a PCB or the like.

In one or more embodiments, the solder material attaching to the peripheral landing regions forms part of the second major surface.

In one or more embodiments, the solder material attaching to the peripheral landing regions extends to the sidewalls.

According to another aspect of the disclosure, there is provided a lead-frame having a uniform thickness and comprising a central die-pad region and a plurality of peripheral landing regions, configured to be integrated into a QFN packaged semiconductor die according to any preceding claim. Providing a lead-frame having a uniform thickness, in particular one which does not require a partial thickness region, may simplify the design and manufacture of the lead-frame, thereby reducing costs.

According to yet another aspect of the disclosure, there is provided a method of manufacturing a QFN packaged semiconductor die, the method comprising: providing a lead-frame, having a lead-frame lower surface and comprising a central die-pad region and a plurality of peripheral landing regions; attached a semiconductor die to the die-pad on a top surface thereof; providing, by means of a plurality of bond-wires, electrical connection between the semiconductor die and the plurality of peripheral landing regions; and encapsulating the semiconductor die and bond-wires with encapsulant material defining a first major surface; wherein the encapsulant material forms a frame extending below the lead-frame lower surface, and defining a second major surface, the frame having an opening therein in a central region thereof under the semiconductor die, and wherein the sidewalls are spaced apart from the frame thereby exposing the lead-frame lower surface at the plurality of peripheral landing regions.

In one or more embodiments, the lead-frame has a uniform thickness. In one or more embodiments, the peripheral landing regions are separated by encapsulant. In one or more embodiments, the method further comprises providing a solder material in the opening.

In one or more embodiments, the solder material in the opening forms part of the second major surface. In one or more embodiments, the method further comprises solder material attaching to the peripheral landings. In one or more embodiments, the solder material attaching to the peripheral landing regions forms part of the second major surface. In one or more such embodiments, the solder material attaching to the peripheral landing regions extends to the sidewalls.

These and other aspects of the invention will be apparent from, and elucidated with reference to, the embodiments described hereinafter.

### Brief description of Drawings

Embodiments will be described, by way of example only, with reference to the drawings, in which
FIG. 1 is a sectional view through a conventional QFN packaged semiconductor device;
FIG. 2 is a perspective view of the underside of a QFN packaged semiconductor device according to embodiments of the present disclosure;
FIG. 3a is a cross-section along A--A' of figure 2;
FIG. 3b is a cross-section along B--B' of figure 2;
FIG. 4 is a perspective view of the underside of a QFN packaged semiconductor device according to other embodiments of the present disclosure;
FIG. 5 is a cross-section along C--C' of figure 4;
FIG. 6 shows a lead-frame assembly for use in one or more embodiments;
FIG. 7 shows the lead-frame assembly 600, covered by a tape;
FIG. 8 shows an enlarged view of a single lead-frame;
FIG. 9a shows a section through a part of a QFN packaged semiconductor device according to embodiments of the disclosure during a later stage of manufacture;
FIG. 9b shows a section through a part of a QFN packaged semiconductor device according to embodiments of the disclosure during a yet later stage of manufacture;
FIG. 9c shows a section through a part of a QFN packaged semiconductor device according to embodiments of the disclosure, after it has been removed from the mold tooling;
FIG. 9d shows a section through a part of a QFN packaged semiconductor device according to embodiments of the disclosure after manufacture;
FIG. 9e shows a section through a part of a QFN packaged semiconductor device according to other embodiments of the disclosure after manufacture;
FIG. 10 shows a schematic of a part processed QFN packaged semiconductor device, at a stage of manufacture corresponding to that shown in FIG. 9b, but for other embodiments of the present disclosure
FIG. 11 shows a flowchart of a method according to one or more embodiments of the present disclosure;
FIG. 12 shows, schematically a partial section through a soldered peripheral landing region according to conventional QFN devices;
FIG. 13a shows, schematically, a partial section through a soldered peripheral landing region according to QFN packaged semiconductor devices according to embodiments of the present disclosure; and
FIG. 13b shows the same region in side view.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments

### Detailed description of embodiments

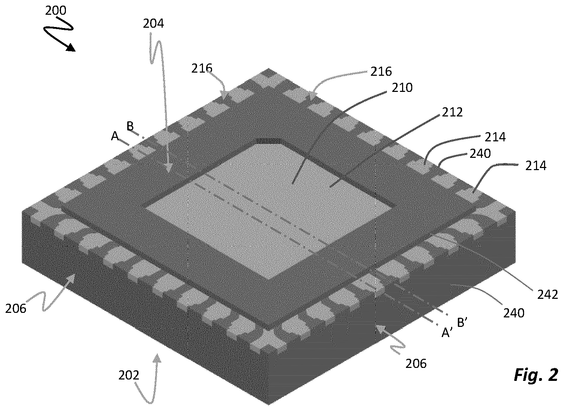

FIG. 2 shows a perspective view of the underside or lower surface of a QFN package 200 according to one or more embodiments of the present disclosure. The QFN packaged semiconductor device has a top or first major surface 202, which is not directly visible in the perspective view, an opposing second or bottom major surface 204, which is pointing upwards in this underside view, and sidewalls 206 therebetween. The QFN package comprises a lead-frame having a lead-frame lower surface, part of which is visible in the figure. The lead-frame comprises a central die-pad region 212 which may also be referred to as a paddle or die-paddle, and a plurality of peripheral landing regions 214. Not visible in FIG. 2, the QFN devices includes a semiconductor die 220, attached to the die-pad, and a plurality of bond-wires 230 providing electrical connection between the semiconductor die, in particular between contact pads on a top or active surface of the semiconductor die, and the plurality of peripheral landing regions. There may be additional bond wires 230 (also not shown in FIG. 2) providing an electrical connection between contact on the top surface of the semiconductor die and the die-pad. Encapsulant material 240 encapsulates the semiconductor die and bond-wires. The encapsulant material 240 defines the first major surface 202 (not visible). The encapsulant material 240 also defines the sidewalls 206 of the QFN device. The sidewalls are comprised nearly entirely of encapsulant material except for the edges of the peripheral landing regions which are near to the second major surface and are exposed on the sidewalls. It will be appreciated that in a conventional QFN package, the exposed edges of the landing regions extend to the second major surface of the QFN device; however as will become more apparent hereafter, in embodiments of the present disclosure, the lead-frame, and thus the exposed edges, do not reach the second major surface of the device. That is to say they do not reach the uppermost surface shown in the figure (which corresponds to the bottom or second major surface as the device as it is typically oriented on a circuit board or the like).

As can be seen in FIG. 2, the encapsulant material forms a frame 242 extending below (in conventional orientation - corresponding to 'above' in the figure) the lead-frame lower surface. This frame is smaller than the QFN and thus its outer perimeter 244 is spaced apart, or recessed, from the sidewalls 206 of the QFN package. The surfaces 216 of the peripheral landing regions are thus exposed around the periphery of the QFN device. The encapsulant material between the exposed surfaces 216 is also exposed, as shown at 218. The frame has an opening therein in a central region thereof, generally under the semiconductor die. In embodiments such as that depicted in FIG. 2, the opening in the frame exposes the die pad. The frame defines the second major surface of the QFN device, that is to say the bottom surface of the QFN device in its normal orientation. The opening in the frame to expose the die pad may therefore be considered to be a recess, or a central recess, from the second major surface. The exposed peripheral landing regions with encapsulant therebetween may similarly be considered to be a recessed perimeter, or a recessed peripheral region, from the second major surface.

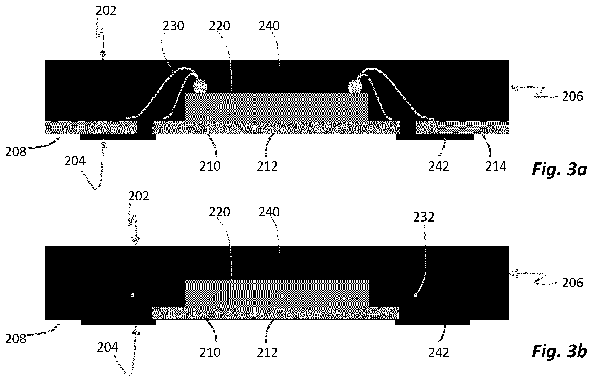

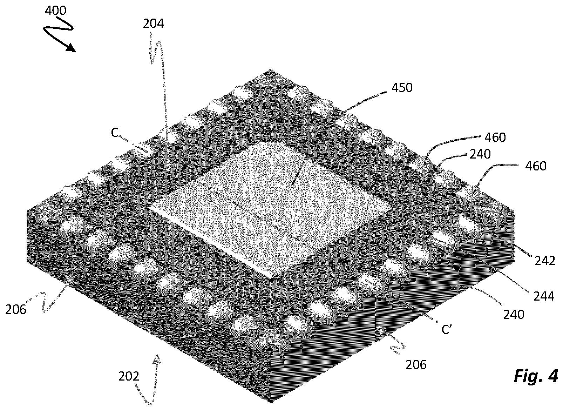

FIG. 3a shows a cross-section along A-A' of FIG. 2, and FIG. 3b shows a cross-section along B -B'. FIG. 4a shows a semiconductor die 220 which is electrically connected to the peripheral landing regions 224 by means of wirebonds 230. In the embodiment shown, wirebonds also provide electrical connection between contact pads (not shown) on the semiconductor die to the die pad 212. The semiconductor die 220 and the wirebonds 230 are encapsulated in encapsulant 240 which defines the first major surface 202. The encapsulant 240 also defines the sidewalls 206 and form the entirety of the sidewalls, apart from the edges of the peripheral landing regions 214. The second major surface 204 of the QFN device is defined by the frame 242. As can be seen the sidewalls 206 do not reach the second major surface. Instead there is a recess 208 between the lowermost part of the sidewalls 206 and the outermost part of the frame 204. As can be seen in the figure, the lead-frame 210, comprising die pad 212 and peripheral landing regions 224, has a uniform, or generally uniform, thickness thereacross.

FIG. 3b, which shows a cross-section along B -B' of FIG. 2, is similar to FIG. 3a except that, since this cross-section does not go through a peripheral landing region, only the die pad 212 part of the lead-frame 210 is visible. Encapsulant 240, which is between the peripheral landing regions, is visible and forms both the sidewall and upper surface of the recess 208 at this part of the device. The skilled person will appreciate that due to the "fan out" between the contacts on the active top surface of the semiconductor die and the peripheral landing regions, some of the bond wires may extend in a direction which is not parallel to the plane of the cross-section of FIG. 3b, and thus the section may intersect a bond wire. This is illustrated by the sections 232 through wires 230 shown.

FIG. 4 shows a perspective view of the underside or lower surface of a QFN package 200 according to one or more other embodiments of the present disclosure. The QFN package is similar to that shown in figure 1 in that it has a first major surface 202 (not visible, and a second major surface 204 which is defined - at least partly - by a frame of encapsulant material. The sidewalls 206 do not extend all the way to the second major surface 204, but are shallower than the QFN device itself. A recessed perimeter or peripheral region surrounds the frame, at a surface height of the lead-frame, and the peripheral landing regions of the lead-frame, along with encapsulant 240 therebetween may be partially exposed in this peripheral region. In particular, outer edges of the peripheral landing regions are visible on the sidewalls. However, in contrast to embodiments such as that shown in FIG. 2, the QFN device shown in FIG. 4 includes solder which attaches to the peripheral landing regions, and to the die pad. Solder 450 in the die pad may fill, or substantially fill, the opening in the frame, and may have a surface which is generally coplanar with the frame. Moreover, solder 460 which attaches to the peripheral landing regions may also have a surface which is generally coplanar with the frame. Of course, the skilled person will appreciate that the solder, in particular that attaching to the landing regions, but also to some extent that in the central opening, may typically not be fully planar, but may "ball up" due to surface tension.

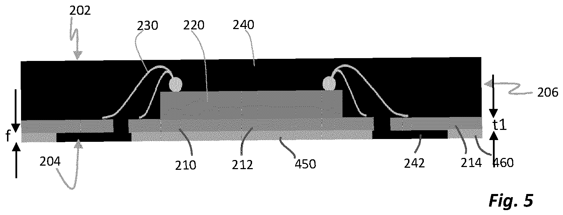

FIG. 5 shows a cross-section along C -C' of FIG. 4. Similar to FIG. 3a, a semiconductor die 220 is electrically connected to the peripheral landing regions 224 by means of wirebonds 230. As shown, wirebonds may also provide electrical connection between contact pads (not shown) on the semiconductor die to the die pad 212. The semiconductor die 220 and the wirebonds 230 are encapsulated in encapsulant 240 which defines the first major surface 202. The encapsulant 240 also defines the sidewalls 206. The sidewalls are formed primarily of the encapsulant, but also include the exposed edges of peripheral landing regions 214. In this embodiment the edges of solder 460 also form part of the sidewall, although the skilled person will appreciate that the solder may, to some extent, retract due to surface tension. Embodiments according to this figure also vary from that shown in FIG. 3a in that solder 450 fills the opening or central recess in the frame 242. The frame 242 and solder 450 are generally coplanar. Of course, the skilled person will appreciate that the figure may be idealised to some extent since no balling, or meniscus, of the solder which may arise due to surface tension is shown. In the embodiment shown in FIG. 5, it is apparent that the lead-frame may have a generally uniform thickness, t, which may typically be of the order of 50 to 200 µm, and in preferred embodiments may be in a range between 100 µm and 125 µm. The thickness, f, of the frame, which corresponds in this embodiment of the thickness of the solder 350 in the central opening and generally to the thickness of the solder 460 attaching to the peripheral landing regions 214, may typically be of the order of 50 to 200 µm, and in preferred embodiments may be in a range between 100 µm and 125 µm, and is typically the same as f

The QFN packaged semiconductor device according to embodiments of the present disclosure may be made from conventional materials. In particular, the lead-frame may conveniently be made of copper or plated copper. In embodiments such as that shown in FIG. 4 which includes solder filling partially filling the recess in and around the encapsulant frame, the solder may be a conventional solder for use in semiconductor processing such as a Sn-Ag-Cu alloy - "(SAC" 305), or 95.4Sn/3.1Ag.1.5Cu.].

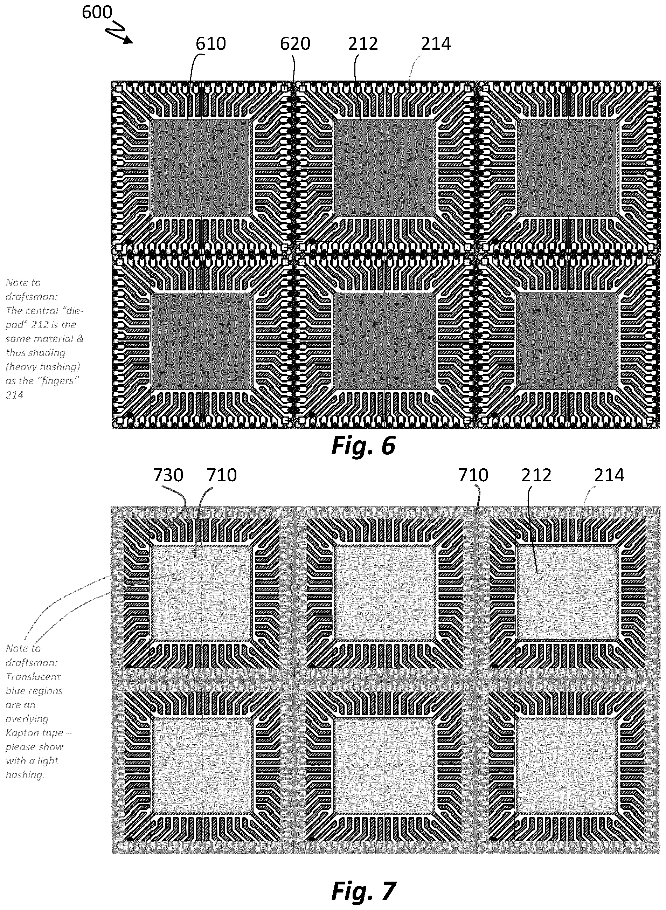

FIG. 6. shows a lead-frame assembly 600 for use in one or more embodiments. Although the FIG. shows a 2-by-3 array of lead-frames 610, the skilled person will appreciate that other sizes of array may be used, or the lead-frame may be provided as a continuous real. The lead-frames are connected together and to each other by bars or frames 620. During later singulation of the devices, the bars or frames will be removed typically by being sawn, which results in separation of the devices and electrical isolation of individual die pads 212 and peripheral landing regions 214.

FIG. 7 shows the lead-frame assembly 600, covered by a tape, such as Kapton tape 710, or other high-temperature stable tape or film which can withstand at least 200°C with degrading [ which has been patterned to expose at least a part of peripheral landing regions 730. The tape is typically a self-adhesive tape. Typically, the tape is deposited across the array of lead-frames, and then patterned so as to align the gaps in the tape with an inner portion of the peripheral landing. An outer perimeter of the die pad 212 may also be exposed by removal of tape from this region.

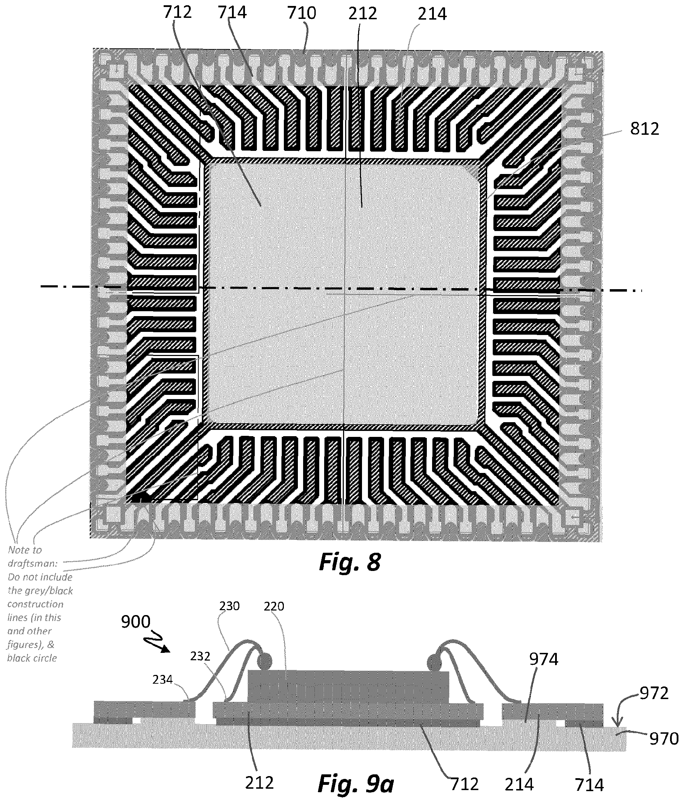

FIG. 8 shows an enlarged view of a single lead-frame, showing more clearly the tape 710 covering most of the die pad 212, at 712, and the outer parts of the peripheral landing regions 214, at 714. The outer perimeter 812 of the die pad 212 is exposed - that is to say it is not covered by the tape. It will be appreciated that, as described above, at this stage of the manufacturing process, the lead-frame is integrated in a lead-frame assembly.

FIG. 9a shows a section through a part of a QFN packaged semiconductor device 900 according to embodiments of the disclosure during a later stage of manufacture. A semiconductor die 220 is mounted on the die pad 212 of the lead-frame, by conventional means (typically by means of an electrically conductive die-attach epoxy not shown). The assembly is placed on a patterned support plate 970. The support plate 970 may also be referred to as a "heat block", since it usually includes a heating element to heat the lead-frame for the wire bonding process, which, as the skilled person will be aware, is conventionally carried out using a combination of thermal, and ultrasonic, energy. The surface of the support plate 970 is generally planar, except for annular, or frame-shaped, regions 974 which protrude above the surface by an amount corresponding to the thickness of the tape 712. As a result, both the wire bonds 230 onto the die pad (that is to say bond shown at 232) and the wirebonds onto the peripheral landing regions (that is to say, bond shown at 234), can be made on well-supported surfaces, at a well- defined height, since the lead-frame has a well-defined thickness, and its lower surface is resting on either the tape 710, which also has a well-defined thickness, or the raised part 974 of the support plate 970. Thus, according to embodiments of the present disclosure, the reliability of the wire bond may be improved relative to conventional QFN, in which the tolerances involved in etching of the lead-frame to a half thickness result in a variable, and to some extent indeterminable, height of the wire bond.

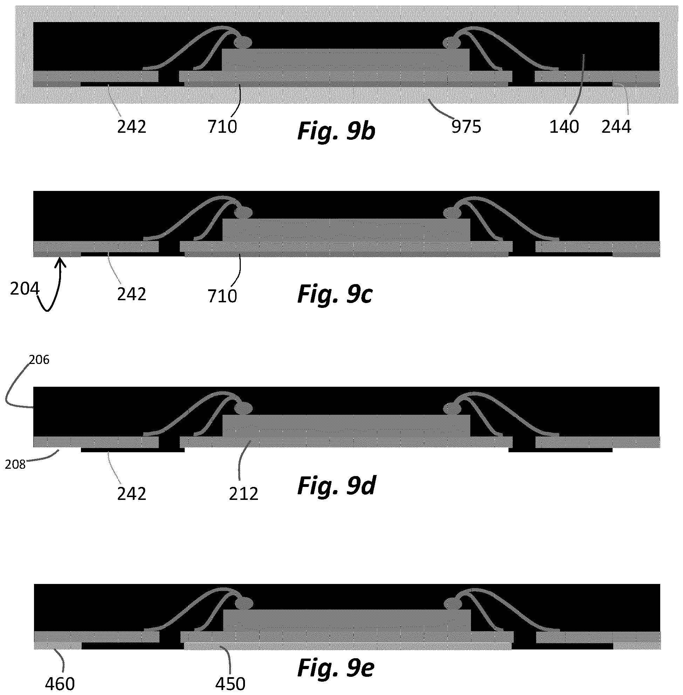

FIG. 9b shows a section through a part of a QFN packaged semiconductor device 900 according to embodiments of the disclosure during a later stage of manufacture. In particular, the assembly of FIG. 9a is placed within a cavity of a mold frame 975, and molding compound 140 is injected into the cavity. As can be seen in Figure, molding compound or encapsulant 140 is extruded into the gap in the tape below the lead-frame. This results in a frame 242 of encapsulant material, with a lower surface which is coplanar with the lower surface of the tape, and has an outer perimeter 244 defined by the outermost edge of the gap in the tape.

FIG. 9c shows a section through a part of a QFN packaged semiconductor device 900 according to embodiments of the disclosure, after it has been removed from the mold tooling.

FIG. 9d shows a section through a part of a QFN packaged semiconductor device 900 according to embodiments of the disclosure after manufacture. According to one or more embodiments, this is the final QFN packaged semiconductor device 900. The tape has been removed, such that the encapsulant frame 242 forms the lower major surface of the QFN package device, around the perimeter of the device there is recess 208, between the lowermost part of the sidewalls 206 and the outermost part of the frame 204. Die pad 212 is exposed in a central opening within the frame 242.

FIG. 9e shows a section through a part of a QFN packaged semiconductor device 900 according to embodiments of the disclosure after manufacture. According to embodiments such as that shown in FIG.9e, manufacture may continue beyond the stage shown in figure 9 D, by providing solder 450 attaching to the die pad in the central opening within the frame, and solder 460 attaching to the peripheral landing regions around the perimeter of the QFN package device. The skilled person will appreciate that, as mentioned above, the solder shown in FIG. 9e may be idealised to some extent, since in practical applications the solder may tend to ball up under the influence of surface tension.

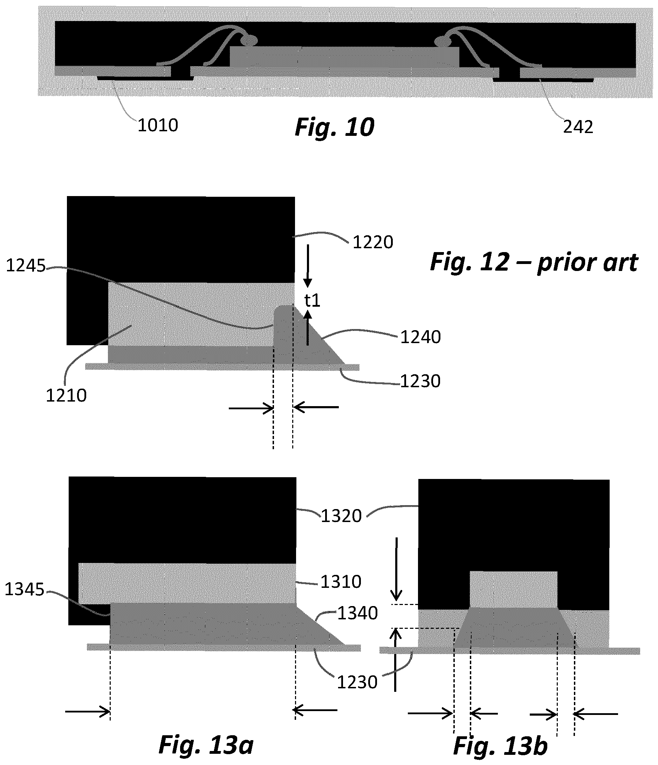

Turning now to FIG. 10, this shows a schematic of a part processed QFN packaged semiconductor device, at a stage of manufacture corresponding to that shown in FIG. 9b, but for other embodiments of the present disclosure. Comparing FIG. 10 with FIG. 9b, it can be seen that in the embodiment shown in FIG. 10, there is no tape 710 on the under-surface of the assembly. Instead of tape defining the boundaries of the frame 242 of epoxy beneath the lead-frame, the boundaries of the frame 242 are defined by the lower plate of the molding tool itself. In other words, the lower plate of the molding tool is not planar but includes recesses therein in positions which will correspond to the encapsulant frame. Of course, the skilled person will appreciate that embodiments such as that shown in figure 10 require accurate placement of the lead-frame assembly within the molding tool. This may be achieved, for instance, using alignments features within the lead-frame assembly. Compared with the method shown in FIG. 9b, methods according to the embodiment shown in FIG. 10, may include wire-bonded of the device simply mounted on a planar support plate, since the lead-frame can be directly supported across the entire device due to its uniform thickness.

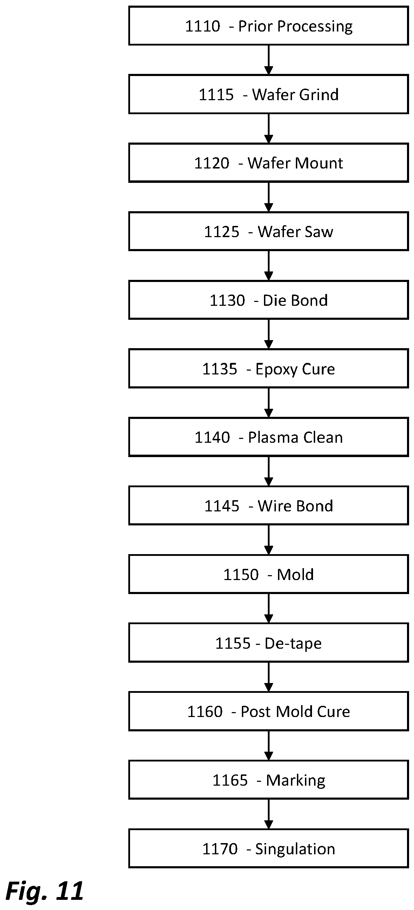

FIG. 11 shows a flowchart of a method according to one or more embodiments of the present disclosure. After prior processing steps shown schematically at 1110, the method continues at step 1115 by grinding a wafer of separate from its original process thickness to its final thickness. The wafer is then mounted at step 1120, and sawn into individual die at step 1125. The die is then bonded to the lead-frame in step 1130, and the electrically conductive epoxy is cured at step 1135 to drive off volatile compounds. The assembly of the die on the lead-frame (with epoxy therebetween) is then subjected to a plasma clean at step 1140. Wire bonding between the contact pads on the active surface of the die and the peripheral landing regions of the lead-frame, and optionally between other contact pads on the active surface of the die and the die pad or paddle is then carried out at step 1145. At step 1150 the assembly is encapsulated with encapsulant molding compound, in a conventional molding tool. At step 1155, the tape defining the encapsulant mold at the bottom major surface is removed, typically by etching, although other means- such as mechanical remove, may be used instead. A post-mold cure, in which the package is heated, to cure the encapsulant and reduce or limit stress, is then applied to the assembly, as shown at step 1160. The assembly (which at this stage typically comprises multiple die each attached to a separate lead-frame within a lead-frame assembly) is then marked for instance to indicate device specific information such as a part-number, or manufacturer logo, as shown at step 1165. The assembly is then singulated into individual QFN packaged semiconductor devices at step 1170.

Turning now to FIG. 12, this shows, schematically a partial section through a soldered peripheral landing region according to conventional QFN devices. The landing region 1210 is embedded in encapsulant 1220. It is electrically connected to a printed circuit board or like 1230 by means of solder 1240. As can been seen, an outermost part of the landing region has a reduced thickness, t1, which is typically half the full-thickness, t, of the lead-frame). Solder 1240 fills the recess left by this reduced thickness, and helps to lock the QFN device in place, and prevent movement or slippage of the device.

FIG. 13a shows, schematically a partial section through a soldered peripheral landing region according to QFN packaged semiconductor devices according to embodiments of the present disclosure, and FIG. 13b shows the same region in side view. Since the lead-frame 1310 has a uniform thickness, it does not include a reduced thickness part. Instead, keying of the device to prevent movement or slippage is provided by the encapsulant frame which extends below the surface of the lead-frame and in particular the peripheral landing regions. The outer perimeter edge 1345 of the frame of encapsulant 1320 locks with the solder 1340. The peripheral landing region 1310 is not directly involved in the locking. Although not shown in the FIGs, the peripheral landing regions may have thereon a plated surface, or may be partially plated. This plated material may interact with, or form a barrier to the solder, during either deposition of the solder, or later attaching - by means of solder - to a PCB or the like.

From reading the present disclosure, other variations and modifications will be apparent to the skilled person. Such variations and modifications may involve equivalent and other features which are already known in the art of QFN devices, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

## Claims

1. A quad flat no-leads (QFN) packaged semiconductor device, having a first major surface (102), an opposing second major surface (204) and sidewalls (206) therebetween, and comprising:
a lead-frame (210), having a lead-frame lower surface and comprising a central die-pad region (212) and a plurality of peripheral landing regions (214);
a semiconductor die (220), attached to the die-pad on a top surface thereof;
a plurality of bond-wires (230) providing electrical connection between the semiconductor die and the plurality of peripheral landing regions; and
encapsulant material (240), encapsulating the semiconductor die and bond-wires and defining the first major surface;
wherein the encapsulant material forms a frame extending below the lead-frame lower surface, and defining the second major surface, the frame having an opening therein in a central region thereof under the semiconductor die, and wherein the sidewalls are spaced apart from the frame thereby exposing the lead-frame lower surface at the plurality of peripheral landing regions.

2. A QFN packaged semiconductor device according to claim 1 wherein the lead-frame has a uniform thickness.

3. A QFN packaged semiconductor device according to claim 1 or 2, wherein the peripheral landing regions are separated by encapsulant.

4. A QFN packaged semiconductor device according to any preceding claim, further comprising a solder material in the opening.

5. A QFN packaged semiconductor device according to claim 4, wherein the solder material in the opening forms part of the second major surface.

6. A QFN packaged semiconductor device according to any preceding claim, further comprising solder material attaching to the peripheral landings.

7. A QFN packaged semiconductor device according to claim 6, wherein the solder material attaching to the peripheral landing regions forms part of the second major surface.

8. A QFN packaged semiconductor device according to claim 6 or 7, wherein the solder material attaching to the peripheral landing regions extends to the sidewalls.

9. A lead-frame (210) having a uniform thickness and comprising a central die-pad region (212) and a plurality of peripheral landing regions (214), configured to be integrated into a QFN packaged semiconductor die according to any preceding claim.

10. A method of manufacturing a QFN packaged semiconductor die, the method comprising:
providing a lead-frame, having a lead-frame lower surface and comprising a central die-pad region and a plurality of peripheral landing regions;
attached a semiconductor die to the die-pad on a top surface thereof;
providing, by means of a plurality of bond-wires, electrical connection between the semiconductor die and the plurality of peripheral landing regions; and
encapsulating the semiconductor die and bond-wires with encapsulant material defining a first major surface;
wherein the encapsulant material forms a frame extending below the lead-frame lower surface, and defining a second major surface, the frame having an opening therein in a central region thereof under the semiconductor die, and wherein the sidewalls are spaced apart from the frame thereby exposing the lead-frame lower surface at the plurality of peripheral landing regions.

11. The method of claim 10 wherein the lead-frame has a uniform thickness.

12. The method of any of claim 10 or 11, further comprising a solder material in the opening.

13. The method of claim 12, wherein the solder material in the opening forms part of the second major surface.

14. The method of any of claims 10 to 13, further comprising solder material attaching to the peripheral landings.

15. The method of claim 14, wherein the solder material attaching to the peripheral landing regions extends to the sidewalls.
